(19) Europäisches Patentamt
European Patent Office
Office européen des brevets

(11) **EP 3 550 730 A1**

(12) **EUROPEAN PATENT APPLICATION**

(43) Date of publication:
09.10.2019 Bulletin 2019/41

(51) Int Cl.:
*H04B 3/54* (2006.01)

(21) Application number: 18305394.1

(22) Date of filing: 03.04.2018

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Ratier-Figeac SAS
46100 Figeac Cedex (FR)**

(72) Inventors:
• **BOUCHET, Arnaud
46100 Planioles (FR)**
• **MERDRIGNAC, Nicolas
46100 Figeac (FR)**

(74) Representative: **Dehns
St. Bride's House
10 Salisbury Square
London EC4Y 8JD (GB)**

(54) **AIRCRAFT COMMUNICATION SYSTEM AND PROTOCOL**

(57)    The system of the present disclosure provides a bus network that allows digital data exchanges over the existing aircraft (115 V) A/C power line and, where present, via the 3-track slip ring that already exists for powering e.g. the de-icing device on a rotating part of the aircraft.

FIG. 1

EP 3 550 730 A1

**Description**

TECHNICAL FIELD

The present disclosure relates to a system for communicating between electronic devices located in different parts of an aircraft and in particular, but not exclusively, to communication between different embedded electronic units such as between an electronic unit in a rotating part such as a rotor or propeller and other electronic units in the aircraft e.g. in the on-board computer.

BACKGROUND

Aircraft are using more and more electronic circuitry. Communication between electronic units in different parts of an aircraft is becoming more desirable and in some cases essential to the efficient and safe operation of the aircraft. In situations where communication between parts is a relatively new requirement or is seen as something that is likely to become desirable or necessary, designers are looking at ways to incorporate communication channels using systems already present in the aircraft, or without too much structural modification, to keep size, weight and costs to a minimum, to minimise the number of additional parts required to be added to the aircraft as each new part will be a potential point of failure.

As an example, de-icing devices are now frequently incorporated in aircraft where ice is likely to accumulate on the ground or during flight. In particular, de-icing systems are found on propeller or rotor blades or on wings. The power supply and control signals for the de-icing systems come from other parts of the aircraft, e.g. the on-board computer. Currently, the electrical connection between the power and control, at a part of the aircraft that is stationary relative to the rotating part, to the de-icing system (or other systems on the rotating part of the aircraft) is provided via 3-track slip rings using a 3-phase 115V A/C supply.

Such systems are described, e.g., in US 6,851,929.

Some systems are known whereby analog sensor data providing information on e.g. temperature, velocity, stress, wear, vibrations etc. of the rotating part can be transmitted from the rotating part to the relatively stationary part, but these require substantial modification of the slip rings, with the analog signals from each sensor being routed via a respective wire and requiring an individual slip ring for each wire. This results in a complex, multi-component, large system with more potential for failure and a higher maintenance load and requires changing existing slip ring structures to add the required data communication.

US 6,851,929 and US 7,602,801 teach systems for powering and controlling a device such as a de-icing device associated with a rotating component on an aircraft. US 2016/0336748 also teaches a system for separately transmitting multiple electric signals to power a rotor component.

US 9,530,307 teaches a system whereby digital information can be transmitted as a single stream of digital data from the rotating component across a signal path formed by a dedicated conductive ring of the slip ring assembly.

The inventors have recognised that there is, or may become, a need to communicate data or information both to and from the de-icing system or other embedded electronic units at a rotating part of the aircraft e.g. the propeller or rotor but that it would be desirable to provide such capability while making using of the already available slip ring connection or without having to modify it substantially.

SUMMARY

The system of the present disclosure provides a bus network that allows digital data exchanges over the existing aircraft (115 V) A/C power line and thus, where present, via the 3-track slip ring that already exists for powering e.g. the de-icing device on a rotating part of the aircraft.

The principle of the communication is based on so-called 'all-or-nothing' communication, where a digital 1, or high level signal, is represented by a sinusoidal signal e.g. a four period 1MHz sinus signal, and a digital 0, or low level signal, is represented by no signal. The number of the periods for the sinusoidal signal can be customised according to need.

Coupling of the interface is performed using voltage induction. This avoids the need for extra devices, e.g. a capacitor link, on the power supply bus. In such a case, the voltage level is dependent on the overall bus impedance, that can vary dynamically. To avoid problems associated with such variations, an automatic gain function is used to adapt the internal voltage level without impacting the voltage level on the power supply bus.

The communication protocol is based on communication between a time master and several time slaves according to a time-triggering communication mechanism. For safety, the fault detection serial bus uses parity and cyclic redundancy check (CRC) mechanisms. A local arbiter can be implemented in each subscriber, as an optional bus failure detection feature. This can detect failure (e.g. endless undulation) and isolate the faulty subscriber from the bus.

BRIEF DESCRIPTION OF THE DRAWINGS

Figure 1 is a schematic view of a system using a communication process of this disclosure.

Figs. 2A and 2B show how data can be transmitted over one phase or three phases of a power line, respectively.

Fig. 3 shows the principle of a time-trigger protocol.

Fig. 4 shows an example of data bus management.

Figs. 5A and 5B show further examples of data bus management.

DETAILED DESCRIPTION

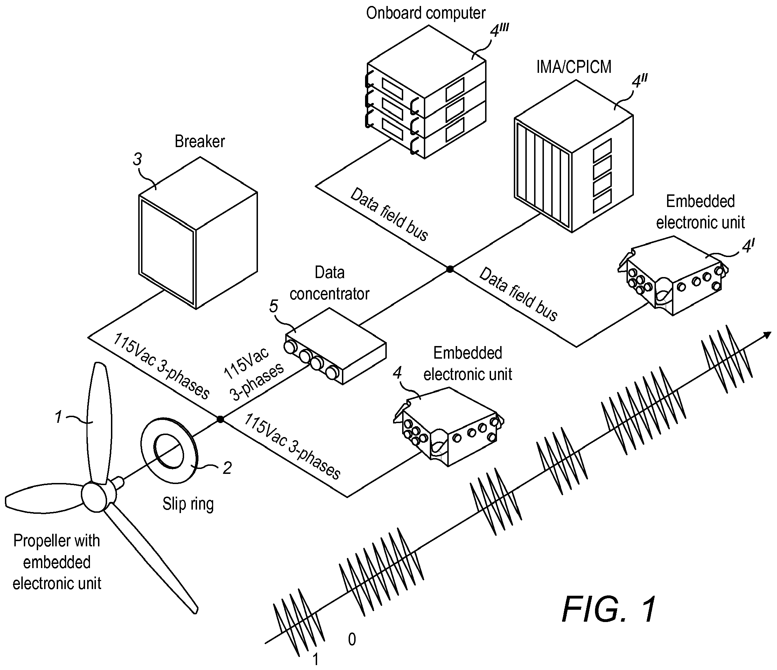

Fig. 1 is a schematic view of a system using the communication process of this disclosure.

The process allows communication to and from embedded electronics in a propeller or other rotating part 1. As described above, the rotating part 1 is conventionally connected to the aircraft power supply and receives control commands via a three track slip ring 2 with each track associated with a respective phase of the three phase supply (usually e.g. 115 V A/C).

Data can be communicated in digital form from the propeller embedded electronics via the existing three tracks of the slip ring 2 to other parts of the aircraft e.g. to embedded electronics in other aircraft systems or computers 4, 4', 4", 4'".

As with conventional systems, the aircraft power (AP) bus can be used directly on the power supply bus connected to a circuit breaker 3 provided on the A/C line.

In the embodiment shown in Fig. 1, data is communicated to the various other parts 4', 4", 4'" over a data field bus. The data is sent over one or more phases of the A/C line, via a data concentrator 5 to the data field bus whereby it is distributed to the appropriate other part, using a traditional avionics bus, e.g. AFDX or CAN ARINC429.

The data is transmitted using a sinusoidal signal over time frames, where presence of the sinusoidal signal represents a digital 1 and absence of the signal represents a digital 0 - i.e. 'all-or-nothing'. This will be described in more detail later.

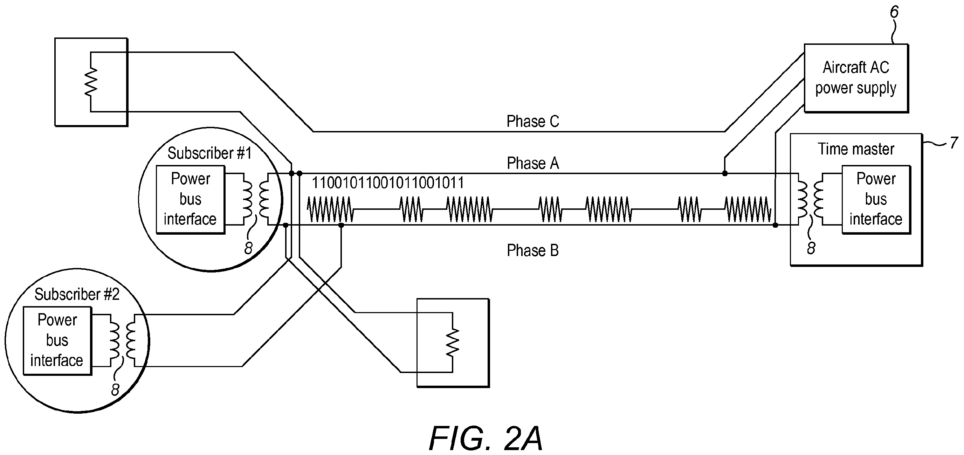

Figure 2A shows how the data can be communicated over one phase (here phase A) of the A/C powerline from the aircraft power supply 6. A timing system 7 controls the transmission of the sinusoidal signal containing the data according to a time triggered principle to the various other embedded electronics or the like. The resistances shown in the figure model the equivalent impedance on the bus.

Each power bus interface is coupled to the data transmission via a decoupling transformer 8. Here, one transformer is provided on the emitter side and one on the receiver side.

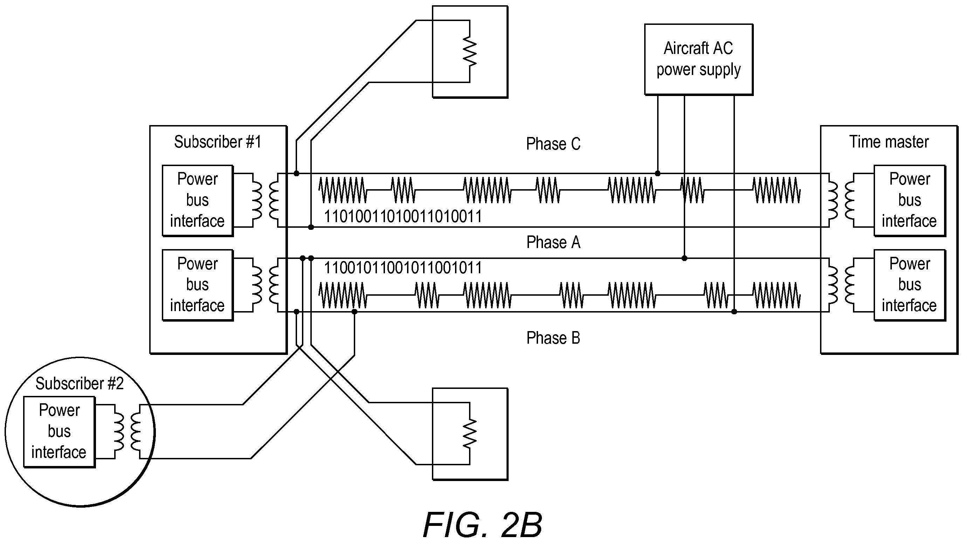

If different data is to be transmitted simultaneously to different receiving electronics, all three phases of the A/C power line can be used to transmit the digital signal as shown in Fig. 2B when redundancy on the bus is requested. The two lines shown for phase A will, in practice, be the same line. Alternatively two identical communication systems could be arranged in parallel on the same two phases, but with two different working frequencies.

The data could also be communicated using a DC power line (not shown).

The power line bus of this disclosure uses, in the preferred embodiment, a universal asynchronous receiver-transmitter (UART) which uses two frequencies - here 0HZ and 1MHz (the above-mentioned 'all-or-nothing' principle). The frequencies can, of course, be selected according to requirements/application. The high-level signal (i.e. a digital 1) is a sinusoidal signal having the characteristics:

$$S(t) = S_{amp} \cdot \sin(2\pi f_0 t + \varphi) + S_{off}$$

The low level signal is a DC signal: $S(t) = S_{off}$
where $S_{off}$ is the offset induced on the A/C bus.

As mentioned above, the communication protocol for the data is based on a time triggered protocol having one time master for each main bus. The serial interface is provided by the UART port of a control component (e.g. MCU, PLD).

The serial data communication, when transmitted on the powerline, will include one start bit and one stop bit and can be configured with even or odd parity for error checking.

Serial data is transmitted in frames as is known, and each frame may include an identifier, a control word, the data and, if required, a CRC field for error checking.

The CRC field can be CRC-16 with polynomial considered 0xAC9A. The CRC computation is performed on the identifier, the control field and the data, but can be left to be configured by the end user if required.

The system is then based on a 'time mastering' mechanism, whereby the time master provides synchronisation to all subscribers to prevent any time lag between them. The time master frame contains information on scheduling and bus management. Each subscriber is then synchronised due to the time master frame and each has its own time allocation defined. Thus, each subscriber knows when to emit their frame according to their internal time scheduler. In order to prevent time shifting due to, e.g., variations in accuracy between the internal clocks of each subscriber, or variations in ambient temperature, the time master frame is sent at the start of each main communication cycle. This reduces the impact of such variations.

Constant bus monitoring is performed by the time master and subscribers to monitor for any unusual activity and prevent resulting bus contention, and to monitor for any breakdown in time scheduling.

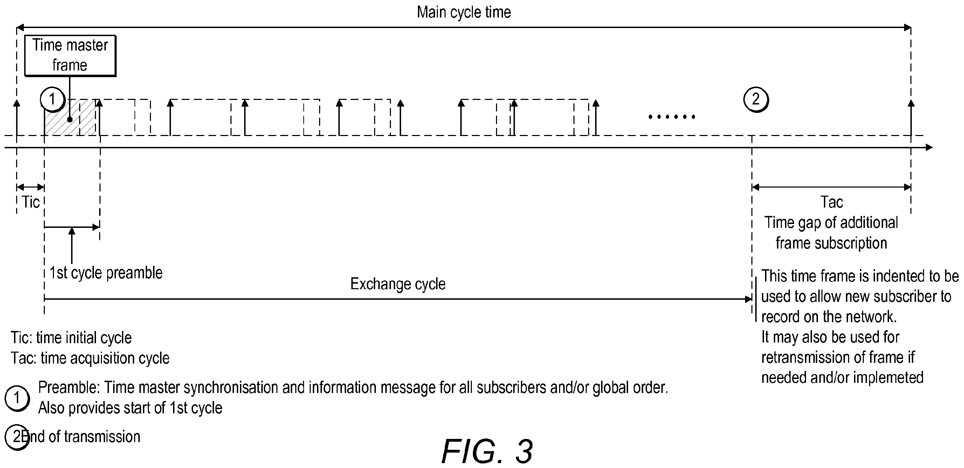

As mentioned above, transmission of the data on the A/C power line is based on a time triggered protocol, an example cycle of which is shown in Fig. 3. The transmission cycle begins with a time initial cycle (Tic) followed by a preamble which starts the data exchange cycle and includes time master synchronisation and an information message for all subscribers (other embedded electronics etc.) and/or global order information. This also provides the start of the first cycle. The data is then communicated in data frames as mentioned above to the end of the transmission, controlled by the time master. A time gap, the 'time acquisition cycle' - Tac- is provided after the exchange cycle to allow other subscribers to request recording on the network and/or to allow for retransmission of frames, if required.

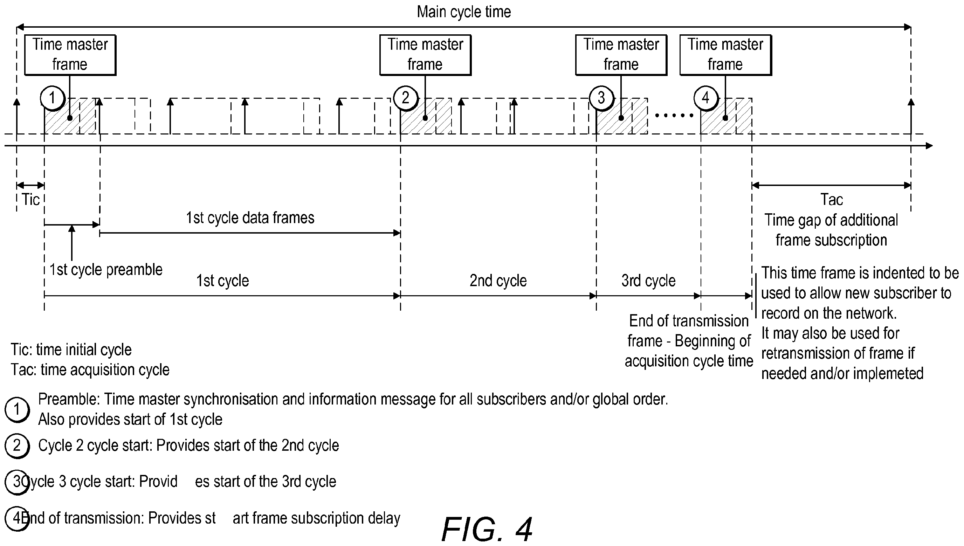

Fig. 4 shows how the bus is managed for several data exchange cycles such as the one shown in Fig. 3.

After the Tic, the first cycle begins with the preamble (as described above) followed by data frames for that first cycle. The start of a second cycle is determined by the time master and this starts where indicated in Fig. 4, again with a preamble followed by data frames. This continues for subsequent cycles and then ends with a Tac, as described above.

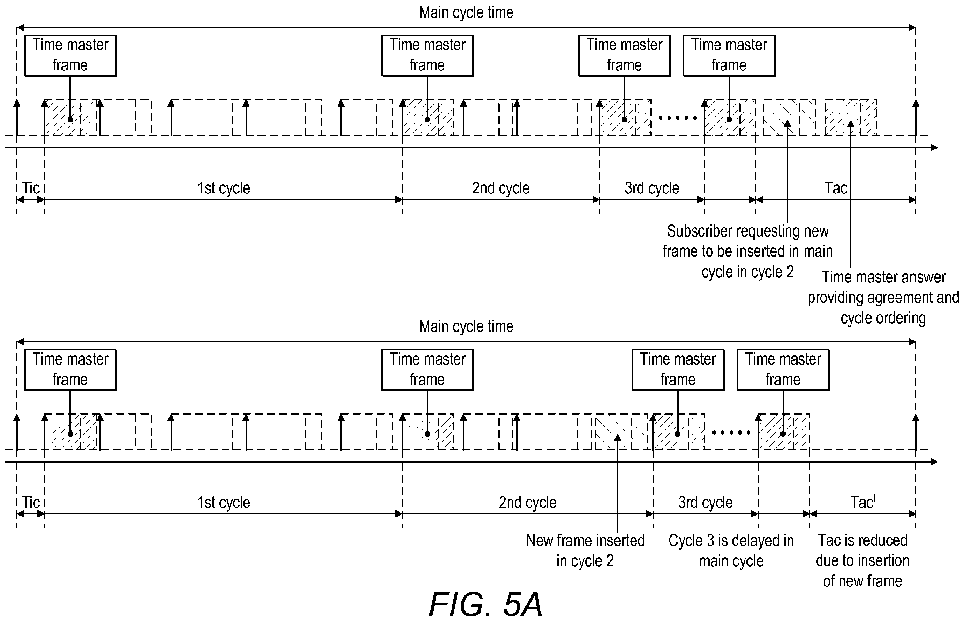

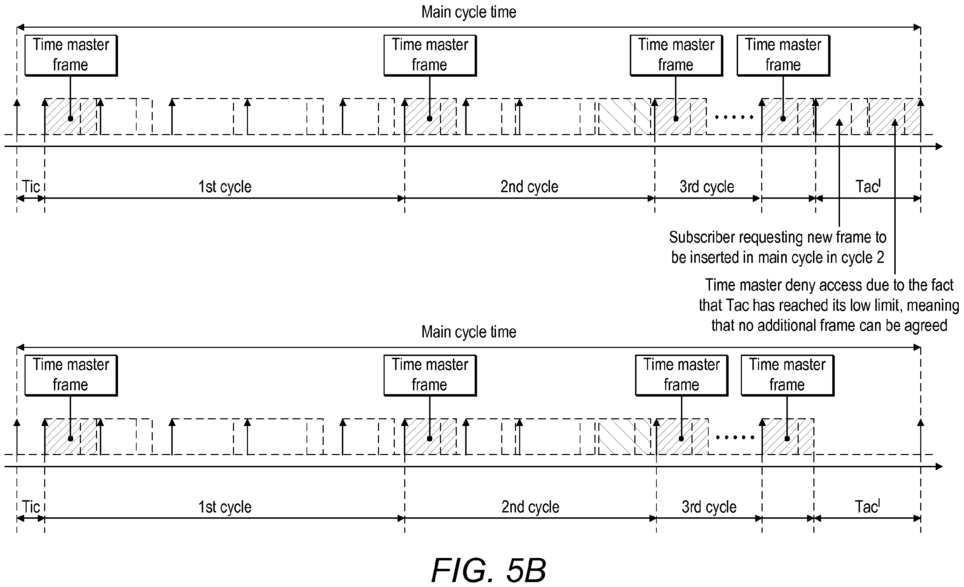

A new subscriber can request access on the bus using a so-called 'door-knocking' mechanism, whereby a subscriber can, during data transmission from other subscribers. 'knock at the door' with a request for a new frame to be inserted in one of the cycles. The time master will acknowledge/agree/refuse. If agreed, the data frame can be inserted, where requested by the subscriber, which alters the timing of other cycles and the length of the Tac accordingly. An example can be seen in Figs. 5A and 5B, whereby, in the Tac, after the third cycle, a subscriber requests that a new frame be inserted in the second cycle. In Fig. 5A, the time master agrees and the frame is inserted. The third cycle is then delayed accordingly and the Tac is also shortened accordingly. In Fig. 5B, the time master refuses the request - perhaps because the Tac is too short.

In preferred embodiments, various safety or protective measures are provided in the system. As mentioned above, the frame identifier and the transmitted data are controlled e.g. using CRC.

The time triggered mechanism also provides protection against failure and bus contention.

The system may also be configured to monitor for a failed emitter - e.g. if no signal is received for a given period of time.

Protection may be provided against the so-called 'babbling idiot' principle. Here, a specific mechanism detects if the emitter has gone into failed mode with endless undulation - i.e. if the emitter had gained access to the bus but then violates timing or timeout rules. The mechanism can cause the emitter to reset.

The communication system thus enables real-time exchange of data from embedded electronics at one aircraft component e.g. a propeller or other rotating part via the A/C power line and, where present, through a three track slip ring to enable the propeller or propeller environment to be monitored - e.g. for the transmission of health monitoring data, de-icing commands, identification commands and the like.

**Claims**

1. A system for communicating data and power between a first component and a remote second component, comprising a power line for providing power to the first component, whereby the power line also provides a data bus for digital transmission of data from the first component to the second component, said data represented by presence and absence of a sinusoidal signal on the data bus; wherein the data transmission comprises representing a digital high level by presence of a sinusoidal signal and a digital low level by absence of a sinusoidal signal and is performed according to a time triggering mechanism, and wherein fault detection is provided on a serial bus using parity and cyclic redundancy check,CRC, mechanisms.

2. An aircraft de-icing system comprising a de-icing device located on a first part of an aircraft and a power line from the de-icing device to a remote power supply located on a second part of the aircraft for providing power to the de-icing device, whereby the power line also provides a data bus for digital transmission of data from the first part to the second part, said data represented by presence and absence of a sinusoidal signal on the data bus; wherein the data transmission comprises representing a digital high level by presence of a sinusoidal signal and a digital low level by absence of a sinusoidal signal and is performed according to a time triggering mechanism, and wherein fault detection is provided on a serial bus using parity and cyclic redundancy check,CRC, mechanisms.

3. The system of claim 1 or 2, wherein the power line is an A/C power line.

4. The system of claim 1 or 2, wherein the power line is a DC power line.

5. The system of any preceding claim, wherein the first component is a rotating component and the second component is a relatively stationary component connected to the first component.

6. The system of claim 5, wherein the first and second components are connected via a 3-track slip ring, and whereby the data and power are communicated via the 3-track slip ring.

7. A method of communicating data and power between a first component and a remote second component, comprising a power line for providing power to the first component, whereby the power line also provides a data bus for digital transmission of data from the first component to the second component, said data represented by presence and absence of a sinusoidal signal on the data bus; wherein the data transmission comprises representing a digital high level by presence of a sinusoidal signal and a digital low level by absence of a sinusoidal signal and is performed according to a time triggering mechanism, and wherein fault detection is provided on a serial bus using parity and cyclic redundancy checkCRC, mechanisms.

FIG. 1

*FIG. 2A*

FIG. 2B

*Main cycle time*

Time master frame

Tic

1st cycle preamble

Exchange cycle

Tac
Time gap of additional frame subscription

This time frame is indented to be used to allow new subscriber to record on the network.
It may also be used for retransmission of frame if needed and/or implemeted

Tic: time initial cycle
Tac: time acquisition cycle

① Preamble: Time master synchronisation and information message for all subscribers and/or global order. Also provides start of 1st cycle

② End of transmission

*FIG. 3*

Main cycle time

Time master frame

Time master frame

Time master frame

Time master frame

Tic

1st cycle data frames

1st cycle preamble

1st cycle

2nd cycle

3rd cycle

End of transmission frame - Beginning of acquisition cycle time

Tac
Time gap of additional frame subscription

This time frame is indented to be used to allow new subscriber to record on the network.
It may also be used for retransmission of frame if needed and/or implemeted

Tic: time initial cycle
Tac: time acquisition cycle

① Preamble: Time master synchronisation and information message for all subscribers and/or global order.
Also provides start of 1st cycle

② Cycle 2 cycle start: Provides start of the 2nd cycle

③ Cycle 3 cycle start: Provid    es start of the 3rd cycle

④ End of transmission: Provides st    art frame subscription delay

*FIG. 4*

EP 3 550 730 A1

FIG. 5A

Main cycle time

Time master frame   Time master frame   Time master frame   Time master frame

Tic   1st cycle   2nd cycle   3rd cycle   Tac¹

Subscriber requesting new frame to
be inserted in main cycle in cycle 2

Time master deny access due to the fact
that Tac has reached its low limit, meaning
that no additional frame can be agreed

Main cycle time

Time master frame   Time master frame   Time master frame   Time master frame

Tic   1st cycle   2nd cycle   3rd cycle   Tac¹

*FIG. 5B*

EP 3 550 730 A1

Europäisches
Patentamt

European
Patent Office

Office européen
des brevets

# EUROPEAN SEARCH REPORT

Application Number

EP 18 30 5394

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/064126 A1 (ISHIKO SHINICHI [JP]) 17 March 2011 (2011-03-17) | 1,4,7 | INV. H04B3/54 |
| A | * paragraph [0058] * <br> * paragraph [0146] - paragraph [0160]; figures 7,9 * | 3,5,6 | |
| X | US 2003/180145 A1 (GOLDBERG JOSHUA I [US]) 25 September 2003 (2003-09-25) | 2-6 | |
| A | * paragraph [0001] - paragraph [0003] * <br> * paragraph [0020] - paragraph [0025] * <br> * paragraph [0031] - paragraph [0039]; figures 2-4 * | 1,7 | |
| X | US 2007/114223 A1 (STONESTREET II ARLIE D [US] ET AL) 24 May 2007 (2007-05-24) <br> * paragraph [0003] * <br> * paragraph [0024] - paragraph [0026] * <br> * paragraph [0045] * <br> * paragraph [0049] * <br> * paragraph [0060] - paragraph [0061] * <br> * paragraph [0065] - paragraph [0066] * <br> * paragraph [0075] - paragraph [0082] * <br> * paragraph [0096] * | 1-7 | |

TECHNICAL FIELDS
SEARCHED (IPC)

H04B

The present search report has been drawn up for all claims

| Place of search | Date of completion of the search | Examiner |
|---|---|---|
| The Hague | 29 June 2018 | D'Alessandro, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 3 550 730 A1**

## ANNEX TO THE EUROPEAN SEARCH REPORT
## ON EUROPEAN PATENT APPLICATION NO.

EP 18 30 5394

29-06-2018

| Patent document cited in search report | | Publication date | Patent family member(s) | | Publication date |
|---|---|---|---|---|---|
| US 2011064126 | A1 | 17-03-2011 | DE 112009001289 | T5 | 22-06-2011 |
| | | | JP 5046345 | B2 | 10-10-2012 |
| | | | JP WO2009145040 | A1 | 06-10-2011 |
| | | | US 2011064126 | A1 | 17-03-2011 |
| | | | WO 2009145040 | A1 | 03-12-2009 |
| US 2003180145 | A1 | 25-09-2003 | NONE | | |
| US 2007114223 | A1 | 24-05-2007 | EP 1951470 | A2 | 06-08-2008 |
| | | | US 2007114223 | A1 | 24-05-2007 |
| | | | US 2008129116 | A1 | 05-06-2008 |
| | | | WO 2007061913 | A2 | 31-05-2007 |

**EP 3 550 730 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6851929 B
- US 7602801 B
- US 20160336748 A
- US 9530307 B